# EUROPEAN PATENT SPECIFICATION

(11) **EP 3 428 972 B1**
(45) Date of publication and mention of the grant of the patent: **11.03.2020**
(21) Application number: 18183260.1
(22) Date of filing: 12.07.2018
(51) Int. Cl.: H01L 29/861, H01L 27/102, H01L 21/329, H01L 29/16, H01L 29/165

(54) **VERTICAL ASYMMETRIC GERMANIUM-BASED TWO-TERMINAL BIRISTOR FOR VERTICAL-TYPE GATELESS AND CAPACITORLESS DRAM CELL AND METHOD FOR MANUFACTURING THEREOF**
VERTIKALER ASYMMETRISCHER ZWEIPOLIGER BIRISTOR AUF GERMANIUM BASIS FÜR VERTIKALE GATELOSE UND KONDENSATORLOSE DRAM-ZELLE UND VERFAHREN ZUR HERSTELLUNG DAVON
BIRISTOR ASYMÉTRIQUE VERTICAL À DEUX BORNES À BASE DE GERMANIUM POUR CELLULE DE DRAM SANS GRILLE ET SANS CONDENSATEUR DE TYPE VERTICAL ET SON PROCÉDÉ DE FABRICATION

(30) Priority: 13.07.2017 KR 20170089041; 05.01.2018 KR 20180001459
(43) Date of publication of application: 16.01.2019
(73) Proprietor: Korea Advanced Institute of Science and Technology, Daejeon 34141 (KR)
(72) Inventor: CHOI, Yang-Kyu, Daejeon 34141 (KR); BAE, Hagyoul, Daejeon 34141 (KR); PARK, Jun-Young, Daejeon 34141 (KR)
(74) Representative: Gill Jennings & Every LLP

(56) References cited:
- WO-A1-2014/092224
- DONG-IL MOON ET AL: "Highly endurable floating body cell memory: Vertical biristor", 2012 INTERNATIONAL ELECTRON DEVICES MEETING (IEDM 2012) : SAN FRANCISCO, CALIFORNIA, USA, 10 - 13 DECEMBER 2012, IEEE, PISCATAWAY, NJ, 10 December 2012 (2012-12-10), pages 31.7.1-31.7.4, XP032341839, DOI: 10.1109/IEDM.2012.6479147 ISBN: 978-1-4673-4872-0
- LAHGERE AVINASH ET AL: "1-T Capacitorless DRAM Using Bandgap-Engineered Silicon-Germanium Bipolar I-MOS", IEEE TRANSACTIONS ON ELECTRON DEVICES, IEEE SERVICE CENTER, PISACATAWAY, NJ, US, vol. 64, no. 4, 1 April 2017 (2017-04-01), pages 1583-1590, XP011643327, ISSN: 0018-9383, DOI: 10.1109/TED.2017.2669096 [retrieved on 2017-03-22]

## Description

### BACKGROUND

### 1. Field of the Invention

The following example embodiments relate to a technology for a semiconductor memory device, further particularly, a vertical-type two-terminal gateless and capacitorless DRAM cell and a method for manufacturing thereof.

### 2. Description of the Related Art

A unit cell of a conventional DRAM memory is a structure (1T/1C) including one transistor (T) and one capacitor (C). In case of a memory device, as the number of cells per unit area increases, it brings commercially and economically excellent effects. Therefore, miniaturizing cell is the biggest problem to solve in a memory industry. To miniaturize cell, miniaturizing the size of transistor or capacitor is a core technology in a conventional DRAM cell structure. As technology is developed, it is possible to miniaturize the size of transistor, but miniaturizing the size of capacitor while maintaining the size of capacitance faces to technical limitation. To solve this problem, a capacitorless DRAM is suggested. Because a unit cell is configured with only one transistor without a capacitor in the capacitorless DRAM, it is advantageous to miniaturize cell. In other words, as it is miniaturized, it may have high density, and manufacturing process is simple, which is advantageous for commercialization. However, in case of the capacitorless DRAM, since a high driving voltage is required in a process of reading and writing memory status, gate insulation degradation occurs, and because of this, there is a critical problem for reliability and durability among memory operation characteristics.

Furthermore, WO 2014/092224 A1 discloses a transistorless and capacitorless DRAM based on a Ge-based vertical type asymmetric two-terminal biristor.

### SUMMARY

According to a first aspect of the invention, there is provided a method for manufacturing a vertical-type asymmetric two-terminal biristor as set out in appended claim 1.

According to a second aspect of the invention, there is provided a vertical-type asymmetric two-terminal biristor as set out in appended claim 10.

At least one example of embodiments may provide a vertical-type asymmetric two-terminal biristor and a method for manufacturing a two-terminal biristor, which may fundamentally solve a problem due to gate insulation degradation occurred in a capacitorelss DRAM having above three-terminal and reduce production cost by omitting processing step for forming gate and gate insulation.

At least one example of embodiments may provide a vertical-type asymmetric two-terminal biristor and a method for manufacturing a two-terminal biristor, which may reduce power consumption by operating in lower voltage by manufacturing based on germanium having small band gap instead of silicon.

At least one example of embodiments may provide a vertical-type asymmetric two-terminal bristor and a method for manufacturing a two-terminal biristor, which may protect germanium which is affected by wet etchant by depositing ACL (Amorphous Carbon Layer) on processing wet etching of ILD (Inter-Layer Dielectric).

At least one example of embodiments may provide a vertical-type asymmetric two-terminal biristor and a method for manufacturing a two-terminal biristor, which may solve reverse leakage current through adjacent cell by using semiconductor layer having asymmetric doping area.

According to the invention, there is provided a method for manufacturing a vertical-type asymmetric two-terminal biristor as set out in claim 1.

The substrate including germanium may include one of pure Ge (germanium), GeOI (Ge on Insulator), or SGOI (Strained Germanium on Insulator).

When the first and third semiconductor layers are formed in N type, and the second semiconductor layer is formed in P type, balance band energy of the first and third semiconductor layers may be lower than balance band energy of the second semiconductor layer, and conduction band energy of the second semiconductor layer may be higher than conduction band energy of the first and third semiconductor layers.

When the first and third semiconductor layers are formed in P type, and the second semiconductor layer is formed in N type, balance band energy of the first and third semiconductor layers may be higher than balance band energy of the second semiconductor layer, and conduction band energy of the second semiconductor layer may be lower than conduction band energy of the first and third semiconductor layers.

The forming second semiconductor layer may include forming the first area to N⁺ and the second area to N⁰ or forming the first area to N⁰ and the second area to N⁺ when the first and third semiconductor layers are formed in P type.

The forming second semiconductor layer may include forming the first area to P⁺ and the second area to P° or forming the first area to P⁰ and the second area to P⁺ when the first and third semiconductor layers are formed in N type.

The forming first and third semiconductor layers may include forming through ion implantation.

Furthermore, annealing for the first and third semiconductor layers may be further included.

The forming first and third semiconductor layers may include forming through epitaxial growth or selective epitaxial growth.

The forming first and third semiconductor layers may include forming energy band gap of the first and third semiconductor layers to be bigger than energy band gap of the second semiconductor layer.

The method may further include patterning and etching the semiconductor layers with activation semiconductor layer, and depositing ILD (Inter-Layer Dielectric) and metal line.

The method may further include depositing ACL (Amorphous Carbon Layer) on the third semiconductor layer in order to protect the third semiconductor layer when etching the ILD.

The method may further include forming sacrificial oxide layer on pillar surface including the first to third semiconductor layers which are vertically formed by the etching.

According to another aspect of at least one example embodiment, a vertical-type asymmetric two-terminal biristor may be manufactured by any one of the above methods.

According to the invention, there is provided a vertical-type asymmetric two-terminal biristor as set out in claim 10.

The substrate based on germanium may be based on one of pure Ge, GeOI, or SGOI.

When the first type is P type, and the second type is N type, the first area may be doped with N⁺ and the second area may be doped with N⁰, or the first area may be dope with N⁰ and the second area may be doped with N+.

When the first type is N type, and the second type is P type, the first area may be doped with P⁺ and the second area may be doped with P⁰, or the first area may be dope with P⁰ and the second area may be doped with P⁺.

When the first type is P type, and the second type is N type, balance band energy of the first and third semiconductor layers may be higher than balance band energy of the second semiconductor layer, and conduction band energy of the second semiconductor layer may be lower than conduction band energy of the first and third semiconductor layers.

When the first type is N type, and the second type is P type, balance band energy of the first and third semiconductor layers may be lower than balance band energy of the second semiconductor layer, and conduction band energy of the second semiconductor layer may be higher than conduction band energy of the first and third semiconductor layers.

The second semiconductor layer may have smaller energy band gap than the first and third semiconductor layers.

According to example embodiments, it may fundamentally solve a problem due to gate insulation degradation occurred in a capacitorless DRAM having above three-terminal and reduce production cost by omitting processing step for forming gate and gate insulation.

According to example embodiments, it may remove affection of wet etchant on a third semiconductor layer by depositing ACL (Amorphous Carbon Layer) on the third semiconductor layer in advance on processing wet etching of ILD (Inter-Layer Dielectric).

According to example embodiments, it may reduce power consumption by operating in lower voltage by manufacturing based on germanium having small band gap instead of silicon.

According to example embodiments, it may solve reverse leakage current through adjacent cell by using semiconductor layer having asymmetric doping area.

### BRIEF DESCRIPTION OF THE DRAWINGS

These and/or other aspects, features, and advantages of the invention will become apparent and more readily appreciated from the following description of embodiments, taken in conjunction with the accompanying drawings of which:
FIG. 1 is a drawing for describing leakage current between adjacent cells in a conventional DRAM;
FIG. 2 is a drawing for describing a structure of a conventional capacitorless DRAM;
FIG. 3 is a drawing for describing a structure of a vertical-type asymmetric two-terminal biristor according to an example of embodiments;
FIG. 4A and FIG. 4B are drawings for describing a method for manufacturing a vertical-type asymmetric two-terminal biristor according to an example of embodiments;
FIG. 5A and FIG. 5B are current-voltage curve of a vertical-type asymmetrictwo-terminal biristor according to an example of embodiments;
FIG. 6 is a drawing for describing a band diagram of a vertical-type asymmetric two-terminal biristor according to an example of embodiments; and
FIG. 7 is a drawing for describing a positive feedback system of a vertical-type asymmetric two-terminal biristor according to an example of embodiments.

### DETAILED DESCRIPTION

Hereinafter, some example embodiments will be described in detail with reference to the accompanying drawings.

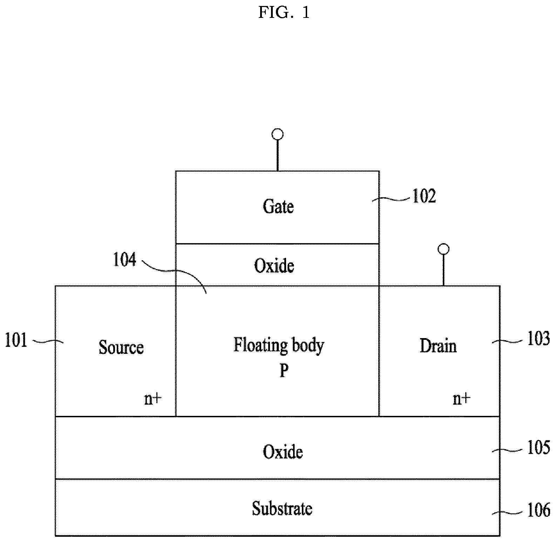

FIG. 1 is a drawing for describing leakage current between adjacent cells in a conventional DRAM.

Referring to FIG. 1, a conventional capacitorless DRAM forms oxide 205 on a substrate 206, forms source 101, a floating body 104, a drain 103 on the oxide 205, and forms oxide and a gate 102 on the floating body 104. Although the source 101, the drain 103, and the gate 102 are electrically connected with the outside, the floating body 104 is electrically floated because the floating body 104 has the oxide on the top and bottom sides and the source and the drain on both sides. Although the source 101, the floating body 104, and the drain 103 may be n, p, n or p, n, n type of semiconductor, it will be described as an example of n, p, n type.

The conventional capacitorless DRAM may use impact ionization effect as a writing method. In other words, when a positive voltage is applied to the drain 103, and also a positive voltage is applied to the gate 102, electron is injected through the source 101, and the injected electron creates impact ionization effect by strong electric field near the drain 103. Electron and hole are generated by impact ionization effect.

Because electron and hole generated between the floating body 104 and the drain 103 try to go to low energy state, the electron goes out to the drain 103, and the hole goes to the floating body 104. Here, when energy gap of the floating body 104 is designed to be smaller than the source 101 and the drain 103, contact potential for electron among contact potential between the floating body 104 and the drain 103 is bigger than contact potential for hole. Therefore, hole came from the drain 103 to the floating body 104 is accumulated, and there are very few holesgoing to the source.

More detailed contents for the conventional capacitorless DRAM may be described through Korean Patent No. 10-1042521.

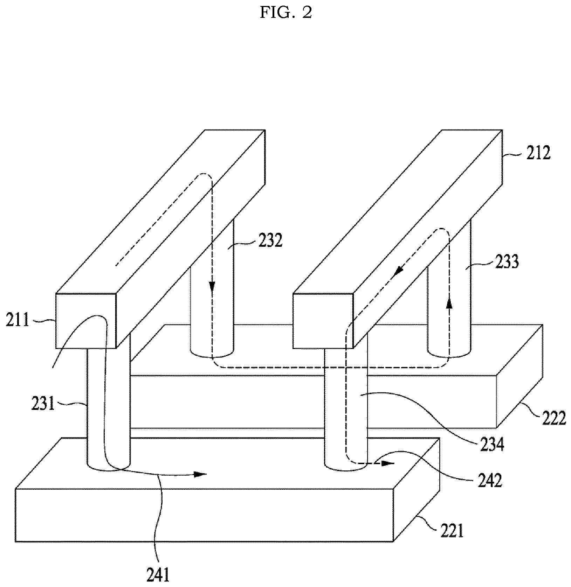

FIG. 2 is a drawing for describing a structure of a conventional capacitorless DRAM.

FIG. 2 shows a part of memory array, and illustrates four cells 231, 232, 233, 234, word lines 211, 212, bit lines 221, 222, data current 241, and leakage current 242.

The data current 241 which is generated when a voltage is applied to the word line 211 has information for a first cell 231. If the spaces between the four cells 231, 232, 233, 234 are small and second, third, and fourth cells are under low resistance state, the leakage current through the second, third, and fourth cells 232, 233, 234 flows in the bit line 221. In this case, because the data current 241 indicating information for the first cell 231 and the leakage current 242 are combined and flow in the bit line 221, there is a problem that information for the first cell 231 may not be accurately known even though the combined current is measured.

Although leakage current was prevented by making an array with adding a diode in the past, abiristoraccording to this invention may solve leakage current problem by adjacent cell so as not to flow reverse current through asymmetric doping.

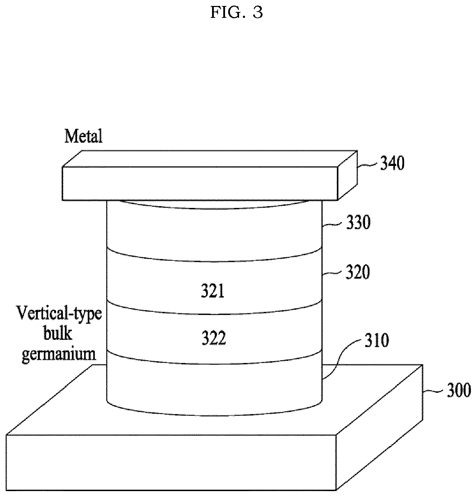

FIG. 3 is a drawing for describing a structure of a vertical-type asymmetric two-terminal biristor according to an example of embodiments.

Referring to FIG. 3, a vertical-type asymmetric two-terminal biristor is a vertical-type structure including a substrate 300, a first semiconductor layer 310, a second semiconductor layer 320, a third semiconductor layer 330, and a metal electrode 340.

Although an area of a unit cell is limited with 8F² or 6F²on characteristic of an existing horizontal-type DRAM, because the asymmetric two-terminal biristoraccording to this invention has vertical-type, an area of a unit cell may be 4F².

The substrate 300 is a material based on germanium having smaller band gap energy than silicon (band gap energy is about 1.12 eV), for example, germanium wafer, Si-Ge (silicon-germanium) alloy based wafer, GOI (germanium on insulator) wafer, SGOI (strained germanium on insulator) wafer.

The wafer may be produced by using at least one of Czochralski method, Floating zone method, Bridgman method, Casting method, EMC (Electro-magnetic casting) method.

The band gap energy is the minimum energy for electron existing in valence band to be excited in conduction band. When the electron of valence band fixed by nucleus gets band gap energy and is excited to conduction band, the electron becomes free electron because it may freely move, and it affects current flow. In other words, if the biristor is created based on germanium which has smaller band gap energy than silicon, it is advantageous to make a low power device because high voltage current may flow in the biristor even though a low voltage is applied.

The semiconductor layers 310, 320, 330 may be formed through epitaxial growth, selective epitaxial growth, or ion implantation.

The epitaxial growth is a process for growing a layer having the same crystal structure with a semiconductor substrate, and for example, it may be PVD (Physical Vapor Deposition), CVD (Chemical Vapor Deposition), MOCVD (Metal-Organic Chemical Vapor Deposition), and ALD (Atomic Layer Deposition).

The selective epitaxial growth is a process for exposing a certain area of a semiconductor substrate, and growing a layer having the same crystal structure with the exposed area. The selective epitaxial growth is easy to produce a semiconductor device having a three-dimensional structure.

The first semiconductor layer 310 and the third semiconductor layer 330 are different types of semiconductor from the second semiconductor layer 320. For example, if the first semiconductor layer 310 and the third semiconductor layer 330 are P type semiconductors, the second semiconductor 320 may be N type semiconductor, and if the first semiconductor layer 310 and the third semiconductor layer 330 are N type semiconductors, the second semiconductor layer 320 may be P type semiconductor.

To flow current in the semiconductor, an external voltage may be applied to each of the first semiconductor layer 310 and the third semiconductor layer 330, and the second semiconductor layer 320 is in floating state thatan external voltage may not be directly applied.

The second semiconductor layer 320 includes a first area 321 and a second area 322 having different doping concentration. A leakage current problem through adjacent cell may be blocked by including the first area 321 and the second area 322 having different doping concentration in the second semiconductor layer 320. For example, when the first semiconductor layer 310 and the third semiconductor layer 330 are formed in N type, the second semiconductor layer 320 is formed in P type, and each of the first and second areas 321, 322 is formed in P⁺ and P⁰, if the first semiconductor layer is grounded, and a voltage is applied to the third semiconductor layer, a current indicating '0' and '1' may flow. On the contrary, if the third semiconductor layer is grounded, and a voltage is applied to the first semiconductor layer, a current does not flow regardless of voltage. Since multiplication factor M and current gain β of impact ionization are different according to two bias conditions, a current flowing in a device is different depending on the bias condition. In other words, because a current does not flow when reverse bias is applied,it may be prevented leakage current from flowing besides the data current 241.

Furthermore, the second semiconductor layer 320 forms an energy well where electric charge may be accumulated since the band gap energy changes band gap by repeatedly forming different substances or, in an embodiment not forming part of the claimed invention, adjusting the rate of Ge in SiGe compound structure.

Here, the second semiconductor layer 320 may be formed by at least one substance of III-IV compound and Si and Ge.

Example of a structure forming the energy well may include GaN/InGaN laminated structure, InAs/In₁₋ₓGaₓAs (e.g., InAs/In_{0.8}Ga_{0.2}As), AlxGai-xAs/GaAs (e.g., Al_{0.2}Ga_{0.8}As/GaAs), and Si/Si₁₋ₓGeₓ (e.g., Si/Si_{0.8}Ge_{0.2}), and here, x may mean a value for adjusting content concentration.

An example of embodiments is a two-terminal structure removing gate and insulator layer in the existing device of three-terminal structure of gate, source, and drain. To indicate '1' state, an electron-hole pair may be formed by impact ionization. If excess hole or electron is accumulated in the second semiconductor layer, it is in low resistance state, so '1' state may be indicated by flowing high current. To indicate '0' state, a voltage of specific bias may be applied to between the first and third semiconductor layers. Because it is in high resistance state by disappearing excess hole or electron in the second semiconductor layer by the specific bias voltage, '0' state may be indicated by flowing low current. Since the two resistance states may be maintained according to bias, the device according to this invention may be defined as Biristor (bistable resistor), and here, DRAM which may determine whether data is stored or not based on current difference of the two states may be implemented.

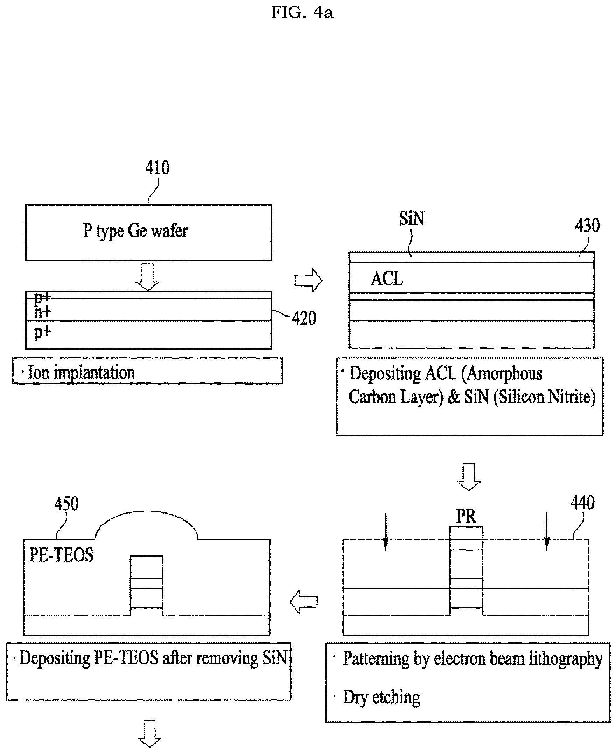

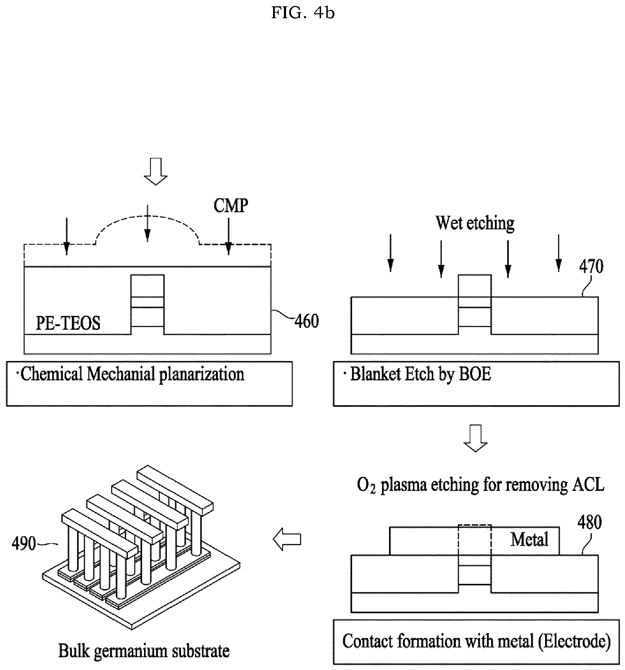

FIG. 4A and FIG. 4B are drawings for describing a method for manufacturing a vertical-type asymmetric two-terminal biristor according to an example of embodiments.

The method includes forming a substrate which is a wafer based on P type germanium S 410. The substrate 300 may be a substance having smaller band gap than silicon (band gap is about 1.12 eV), for example, germanium wafer, GOI (Germanium on Insulator) wafer, SGOI (Strained Germanium on Insulator) wafer.

The wafer may be produced by using at least one of Czochralski method, Floating zone method, Bridgeman method, Casting method, and EMC (Electro-Magnetic Casting) method.

After S410, forming a semiconductor layer on the germanium based substrate may be included S420. As a method for forming the semiconductor layer, at least one of epitaxial growth, selective epitaxial growth, ion implantation may be used. Here, when forming the semiconductor layer with ion implantation, different types of semiconductor layer may be formed by adjusting acceleration energy of ion implantation and dose amount of impurities. Also, by including annealing, implanted ion may be activated, and distribution of the implanted ion may be adjusted as desired form. Annealing is a method for heating a semiconductor at a high temperature for a specific time period, and then, cooling relatively slowly.

When forming the second semiconductor layer, doping concentration of the bottom may be lower than doping concentration of the top. Current may flows as desired direction by making different doping concentration. In other words, it may be prevented from occurring undesired current by being affected by adjacent cell.

After S420, it may include depositing a hard mask in order to form an active semiconductor layer S430. The hard mask performs a role to prevent desired circuit pattern from being etched. In an example of embodiments, the hard mask may be a substance such as armorphous carbon, Si₃N₄, and SiO₂. For example, by depositing ACL (Armorphous Carbon Layer) on the third semiconductor layer, afterward in an etching process, it may be prevented the third semiconductor layer from being etched at least partly.

After S430, an example of embodiments may include patterning and dry etching S440. After depositing PR (Photoresist) on the hard mask, the active semiconductor layer may be formed through patterning with Electron Beam Lithography and dry etching. Here, when arraying cell, since the bottom of the first semiconductor layer may be used as common electrode, the bottom of the first semiconductor layer may be saved when etching. The process for patterning may be a method for recording circuit pattern of nano scale such as X-ray lithography as well as Electron Beam Lithography.

Furthermore, this invention may improve characteristics of the biristor by removing defect of Ge pillar surface which is the vertically formed first to third semiconductor layers by additionally performing sacrificial oxidation after dry etching. In case of the two-terminal biristor, it is very important characteristic that electric charges additionally generated by impact ionization are maintained on the second semiconductor layer which is a base area without being recombined. However, in the case of dry etching which proceeds to form Ge pillar, it may physically damage around Ge pillar. Therefore, this invention may remove defect state of Ge pillar surface by performing sacrificial oxidation, and improve characteristics of the biristor including reducing operation voltage, increasing electric charge storage retention time and reliability of cyclic endurance, and the like.

After S440, it may include depositing insulating substance after removing PR and SiNS450. An example of embodiments may block unnecessary electric interaction between activated semiconductor layers by depositing PE-TEOS. Therefore, substance which may perform a role of ILD as well as PE-TEOS may be deposited.

After S450, it may include planarization in order to make precise semiconductor device S460. A method for planarization may be used such as Chemical Mechanical Planarization and the like.

After S460, it may include etching in order to remove remaining hard mask part which is ACL (Amorphous Carbon Layer) in an example of embodimentsS470. Since electrical interaction between semiconductor layers is blocked by the insulating substance, large amounts of substrates may be processed through wet etching rather than precisely etching. For example, Blanket Etch may be performed with BOE (Buffered Oxide Etch) solution that NH₄F solution and HF solution are mixed at 6:1 ratio as a buffer solution. Blanket Etch is an etching technology for thinly etching surface. The hard mask deposited on the third semiconductor layer, for example, ACL exists between the buffer solution and the third semiconductor layer. Therefore, it may prevent the third semiconductor layer from etching by being affected by the buffer solution.

After S470, it may include removing the remaining hard mask and forming metal electrode S480. An example of embodiments may use a semiconductor etching method such as etching through plasma oxidation as a method for removing the remaining hard mask.

An array of a vertical-type two-terminal biristor based on germanium may be formed through a method by S410 to S480, S490. As shown in S490, to give various bias conditions through external voltage, cells which are arrayed in the same column may be connected with the bottom part of the first semiconductor layer, and cells which are arrayed in the same row may be connected with metal electrode. When comparing with a conventional three-terminal semiconductor, because it does not have a gate, it may perform a role of DRAM with two-terminal, and it may perform a role of a capacitor because it may maintain quantity of electric charge by excess carrier collected in the second semiconductor layer. Also, because leakage current by adjacent cell is small due to asymmetric doping area of the second semiconductor layer, current containing information of the desired cell may be obtained with high accuracy.

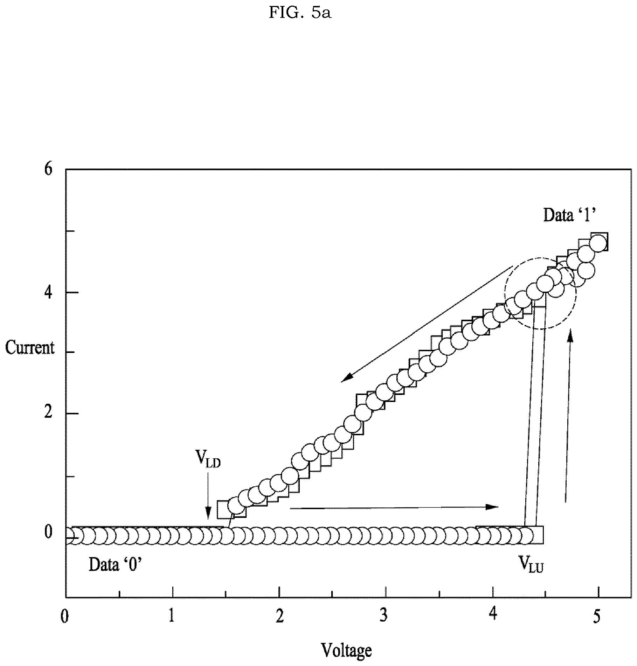

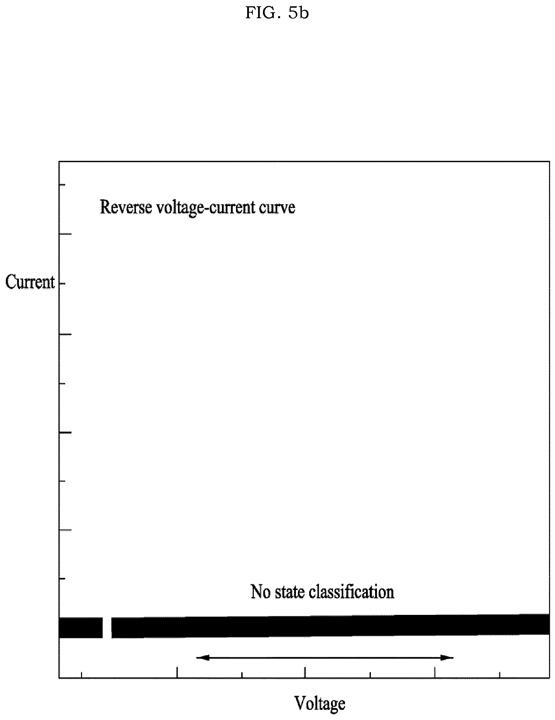

FIG. 5A and FIG. 5B are current-voltage curve of a vertical-type asymmetric two-terminal biristor according to an example of embodiments.

In case that first, second, and third semiconductors are each of N, P, and N types, when a voltage of the third semiconductor layer increases, impact ionization occurs by high electric field formed between the second and third semiconductor layers, and EHPs (Electron Hole pairs) are generated. Excess electrons pass through the second semiconductor layer to the third semiconductor layer, and when a voltage reaches to a specific value, large current flows such as BJT (Bipolar Junction Transistor) whose base is opened is in breakdown region. Here, current of large value is maintained as long as the voltage of above specific value is applied. If the voltage reduces again, generation of EHPs reduces, and it is again out of the breakdown region, so small current flows. The voltage which is out of the breakdown region (hereafter, latch down voltage V_{LD} is smaller than the voltage which occurs in the breakdown region (hereafter, latch up voltage V_{LU}, so there is bistable current-voltage characteristic between V_{LD} and V_{LU}. States that excess holes are collected or not collected in the second semiconductor layer may be sensed between V_{LD} and V_{LU}. According to the collected state of the excess carrier, current flows much or less. Therefore, it may distinguish whether the stored data is "1" state or "0" state.

In other words, when a positive voltage is applied to the third semiconductor layer, and the first semiconductor layer is grounded, as illustrated in FIG. 5A, drain current rarely flows until V_{LU} is reached, and the drain current rapidly rises by impact ionization when V_{LU} is reached. Here, a rapid increase of current occurs when satisfying (M-1)^{∗}β ≒ 1. M is multiplication factor, and represents the ratio between current before impact and current by impact. β is current gain, and represents the ratio between base current and collector current in BJT. The multiplication factor M increases proportionally with a voltage applied to the third semiconductor layer. The current gain is described in detail in KR 10-1042521.

The hole by impact ionization is collected in the second semiconductor layer, and in low resistance state, so it may maintain high current although the voltage is lowered to some extent.

FIG. 5B illustrates current-voltage curve in case that a negative voltage is applied to the third semiconductor layer, and the first semiconductor layer is grounded. In case of the voltage of the same absolute value, when applying a negative voltage than applying a positive voltage, multiplication factor and current gain are small. Therefore, because (M-1)^{∗}β ≒ 1 may be satisfied only when applying bigger absolute value than applying the positive voltage, it is observed that no current flows in voltage section such as FIG. 5B.

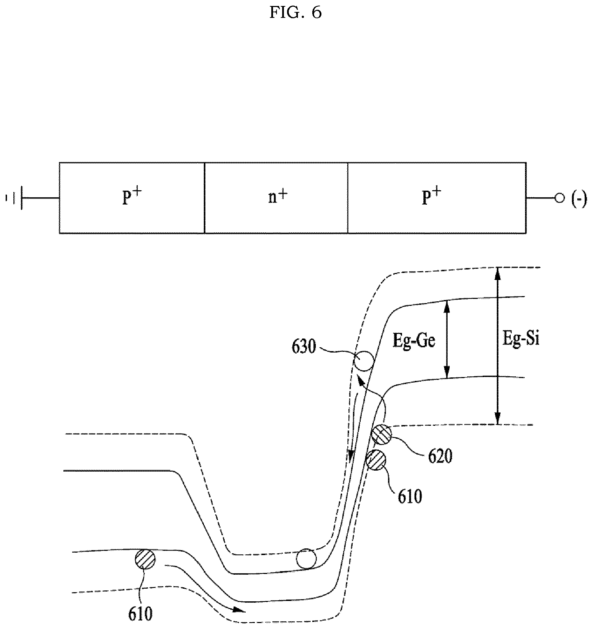

FIG. 6 is a drawing for describing a band diagram of a vertical-type asymmetric two-terminal biristor according to an exampleof embodiments.

Referring to FIG. 6, band gap energy of two-terminal birister based on Ge is smaller than band gap energy of two-terminal biristor based on Si. When the two-terminal biristor based on Ge having small band gap energy is compared with the biristor based on Si, it has an advantage that large current may flow by a small voltage. Therefore, the vertical-type asymmetric two-biristor according to this invention may be usefully used in manufacturing low power device.

Also, referring to FIG. 6, in an example of embodiments, first and third semiconductor layers may be formed in P type, and a second semiconductor layer may be formed in N type. When voltage level applied to the third semiconductor layer increases on a state that the first semiconductor layer is short-circuited, a hole 610 is injected, and the hole 610 is over contact potential between the first semiconductor layer and the second semiconductor layer. Then, impact ionization occurs by a high voltage between the second semiconductor layer and the third semiconductor layer, and electron-hole pair 620, 630 is generated. An excess hole 620 goes to the third semiconductor layer and becomes a part of drain current, and the excess electron 630 may not go to the first semiconductor layer by contact potential between the first semiconductor layer and the second semiconductor layer, and makes energy band high by being collected in the second semiconductor layer. As electrons are accumulated in the second semiconductor layer, contact potential of the hole viewing the second semiconductor layer from the first semiconductor layer is lower, so more holes are injected. As more holes are injected, there are more electron-hole pairs generated by impact ionization, so drain current is larger. Therefore, the vertical-type asymmetric two-terminal biristor according to this invention is a device having positive feedback.

Energy band gap of the first and second semiconductor layers and the second semiconductor layer may be different depending on material of each of layers.

Referring to FIG. 6, when comparing energy band gap of the first and third semiconductor layers and the second semiconductor layer, it may be shown that energy band gap of the first and third semiconductor layers is bigger than energy band gap of the second semiconductor layer. If energy band gap of the second semiconductor layer is made smaller than energy band gap of the first semiconductor layer and the third semiconductor layer, contact potential for the hole between the first semiconductor layer and the second semiconductor layer is lower, so the hole may easily go to the third semiconductor layer. On the contrary, because contact potential for the electron between the first semiconductor layer and second semiconductor layer is higher, there is high possibility that the electron moving down from the third semiconductor layer to the second semiconductor layer by impact ionization is blocked by contact potential, so it may not move to the first semiconductor layer, and be accumulated.

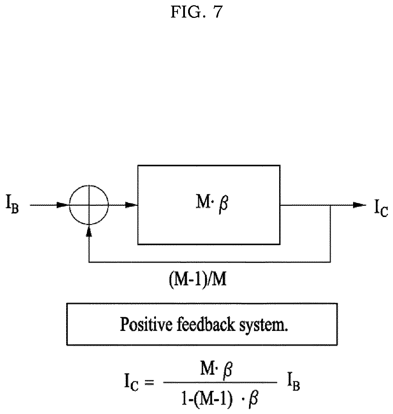

FIG. 7 is a drawing for describing a positive feedback system of a vertical-type asymmetric two-terminal biristor according to an example of embodiments.

Electron-hole pair generated by impact ionization generates another electron-hole pair by impact ionization again, and electrons accumulated in the second semiconductor layer makes contact potential lower, so larger current may flow.

When there is no feedback system, drain current Ic is a value that current I_{B} flowing in the second semiconductor layer is multiplied by multiplication M and current gain β. Because the vertical-type asymmetrictwo-terminal biristor according to this invention has a positive feedback, a value obtained by multiplying drain current of the opened system and (M-1)/M is input again.

While certain example embodiments and implementations have been described herein, other embodiments and modifications will be apparent from this description. Accordingly, the invention is not limited to such embodiments, but its scope is defined only by the appended claims.

## Claims

1. A method for manufacturing a vertical-type asymmetric two-terminal biristor comprising:
forming a first semiconductor layer (310) on a substrate (300) including germanium;
forming a second semiconductor layer (320) based on germanium including a first area (321) and a second area (322) which have different doping concentration on the first semiconductor layer; and
forming a third semiconductor layer (330) based on germanium on the second semiconductor layer,
and the conductivity type of the first and third semiconductor layers is different from the conductivity type of the second semiconductor layer,
the method being **characterised in that** the forming the second semiconductor layer forms the second semiconductor layer by laminating a plurality of substances having different band gap energy in order to form an energy well.

2. The method of claim 1, wherein the substrate including germanium comprises one of pure Ge (germanium), GeOI (Ge on Insulator), or SGOI (Strained Germanium on Insulator).

3. The method of claim 1, wherein when the first and third semiconductor layers are formed in N type, and the second semiconductor layer is formed in P type, balance band energy of the first and third semiconductor layers are lower than balance band energy of the second semiconductor layer, and conduction band energy of the second semiconductor layer is higher than conduction band energy of the first and third semiconductor layers.

4. The method of claim 1, wherein when the first and third semiconductor layers are formed in P type, and the second semiconductor layer is formed in N type, balance band energy of the first and third semiconductor layers are higher than balance band energy of the second semiconductor layer, and conduction band energy of the second semiconductor layer is lower than conduction band energy of the first and third semiconductor layers.

5. The method of claim 1, wherein the forming second semiconductor layer comprises forming the first area to N⁺ and the second area to N⁰ or forming the first area to N⁰ and the second area to N⁺ when the first and third semiconductor layers are formed in P type.

6. The method of claim 1, wherein the forming second semiconductor layer comprises forming the first area to P⁺ and the second area to P° or forming the first area to P⁰ and the second area to P⁺ when the first and third semiconductor layers are formed in N type.

7. The method of claim 1, wherein the forming first to third semiconductor layers comprises forming energy band gap of the first and third semiconductor layers to be bigger than energy band gap of the second semiconductor layer.

8. The method of any one of claims 1 to 7 further comprising patterning and etching the semiconductor layers to form an active semiconductor layer; and depositing ILD (Inter-Layer Dielectric) and metal line.

9. The method of claim 8, wherein the etching forms a pillar, the method further comprising forming sacrificial oxide layer on pillar surface including the first to third semiconductor layers which are vertically formed by the etching.

10. A vertical-type asymmetric two-terminal biristor comprising:
a substrate (300) based on germanium;
a first semiconductor layer (310) of a first conductivity type formed on the substrate;
a second semiconductor layer (320) of a second conductivity type formed on the first semiconductor layer and including a first area (321) and a second area (322) which have different doping concentration; and
a third semiconductor (330) of the first conductivity type formed on the second semiconductor layer,
the biristor being **characterised in that** the second semiconductor layer is formed by laminating a plurality of substances having different band gap energy in order to form an energy well.

11. The vertical-type asymmetrictwo-terminal biristor of claim 10, wherein when the first type is P type, and the second type is N type, the first area is doped with N⁺ and the second area is doped with N⁰, or the first area is dope with N⁰ and the second area is doped with N⁺.

12. The vertical-type asymmetrictwo-terminal biristor of claim 10, wherein when the first type is N type, and the second type is P type, the first area is doped with P⁺ and the second area is doped with P⁰, or the first area is dope with P⁰ and the second area is doped with P⁺.

13. The vertical-type asymmetrictwo-terminal biristor of claim 10, wherein when the first type is P type, and the second type is N type, balance band energy of the first and third semiconductor layers is higher than balance band energy of the second semiconductor layer, and conduction band energy of the second semiconductor layer is lower than conduction band energy of the first and third semiconductor layers.

14. The vertical-type asymmetrictwo-terminal biristor of claim 10, wherein when the first type is N type, and the second type is P type, balance band energy of the first and third semiconductor layers is lower than balance band energy of the second semiconductor layer, and conduction band energy of the second semiconductor layer is higher than conduction band energy of the first and third semiconductor layers.

## Patentansprüche

1. Verfahren zum Herstellen eines asymmetrischen bistabilen zweipoligen Widerstands vom vertikalen Typ, umfassend:
Ausbilden einer ersten Halbleiterschicht (310) auf einem Substrat (300), das Germanium enthält;
Ausbilden einer zweiten Halbleiterschicht (320) auf Germaniumbasis, die einen ersten Bereich (321) und einen zweiten Bereich (322) einschließt, die unterschiedliche Dotierungskonzentrationen auf der ersten Halbleiterschicht aufweisen; und
Ausbilden einer dritten Halbleiterschicht (330) auf Germaniumbasis auf der zweiten Halbleiterschicht, wobei der Leitfähigkeitstyp der ersten und der dritten Halbleiterschicht sich von dem Leitfähigkeitstyp der zweiten Halbleiterschicht unterscheidet, wobei das Verfahren **dadurch gekennzeichnet ist, dass** das Ausbilden der zweiten Halbleiterschicht die zweite Halbleiterschicht durch Laminieren mehrerer Substanzen ausbildet, welche unterschiedliche Bandlückenenergien aufweisen, um eine Energiequelle zu erzeugen.

2. Verfahren nach Anspruch 1, wobei das Substrat, das Germanium aufweist, eines von Folgendem umfasst: reinem Ge (Germanium), GeOI (Ge on Insulator, Germanium auf Isolator) oder SGOI (Strained Germanium on Insulator, verspanntem Germanium auf Isolator).

3. Verfahren nach Anspruch 1, wobei, wenn die erste und die dritte Halbleiterschicht nach dem N-Typ ausgebildet sind und die zweite Halbleiterschicht nach dem P-Typ ausgebildet ist, die Ausgleichsbandenergie der ersten und der dritten Halbleiterschicht niedriger ist als die Ausgleichsbandenergie der zweiten Halbleiterschicht, und die Leitungsbandenergie der zweiten Halbleiterschicht höher ist als die Leitungsbandenergie der ersten und dritten Halbleiterschicht.

4. Verfahren nach Anspruch 1, wobei, wenn die erste und die dritte Halbleiterschicht nach dem P-Typ ausgebildet sind und die zweite Halbleiterschicht nach dem N-Typ ausgebildet ist, die Ausgleichsbandenergie der ersten und der dritten Halbleiterschicht höher ist als die Ausgleichsbandenergie der zweiten Halbleiterschicht, und die Leitungsbandenergie der zweiten Halbleiterschicht niedriger ist als die Leitungsbandenergie der ersten und dritten Halbleiterschicht.

5. Verfahren nach Anspruch 1, wobei das Ausbilden der zweiten Halbleiterschicht das Ausbilden des ersten Bereichs bis zu N⁺ und des zweiten Bereichs bis zu N⁰ oder das Ausbilden des ersten Bereichs bis zu N⁰ und des zweiten Bereichs bis zu N⁺ umfasst, wenn die erste und die dritte Halbleiterschicht nach dem P-Typ ausgebildet sind.

6. Verfahren nach Anspruch 1, wobei das Ausbilden der zweiten Halbleiterschicht das Ausbilden des ersten Bereichs bis zu P⁺ und des zweiten Bereichs bis zu P⁰ oder das Ausbilden des ersten Bereichs bis zu P⁰ und des zweiten Bereichs bis zu P⁺ umfasst, wenn die erste und die dritte Halbleiterschicht nach dem N-Typ ausgebildet sind.

7. Verfahren nach Anspruch 1, wobei das Ausbilden der ersten bis zur dritten Halbleiterschicht das Ausbilden einer Energiebandlücke der ersten und der dritten Halbleiterschicht umfasst, die größer ist als die Energiebandlücke der zweiten Halbleiterschicht.

8. Verfahren nach einem der Ansprüche 1 bis 7, ferner umfassend das Mustern und das Ätzen der Halbleiterschichten, um eine aktive Halbleiterschicht auszubilden; und
das Abscheiden von ILD (Inter-Layer Dielectric, Zwischenschicht-Dielektrikum) und Metallleitung.

9. Verfahren nach Anspruch 8, wobei das Ätzen eine Säule ausbildet, wobei das Verfahren ferner das Ausbilden einer Opferoxidschicht auf der Säulenoberfläche umfasst, wobei dies die erste bis die dritte Halbleiterschicht einschließt, die durch das Ätzen vertikal ausgebildet sind.

10. Asymmetrischer bistabiler zweipoliger Widerstand vom vertikalen Typ, umfassend:
ein Substrat (300) auf Germaniumbasis;
eine erste Halbleiterschicht (310) eines ersten Leitfähigkeitstyps, die auf dem Substrat ausgebildet ist;
eine zweite Halbleiterschicht (320) eines zweiten Leitfähigkeitstyps, die auf der ersten Halbleiterschicht ausgebildet ist und die einen ersten Bereich (321) und einen zweiten Bereich (322) aufweist, die unterschiedliche Dotierungskonzentrationen aufweisen; und
einen dritten Halbleiter (330) des ersten Leitfähigkeitstyps, der auf der zweiten Halbleiterschicht ausgebildet ist, wobei der bistabile Widerstand **dadurch gekennzeichnet ist, dass** die zweite Halbleiterschicht durch Laminieren mehrerer Substanzen mit unterschiedlicher Bandlückenenergie ausgebildet ist, um eine Energiequelle zu erzeugen.

11. Asymmetrischer bistabiler zweipoliger Widerstand vom vertikalen Typ nach Anspruch 10, wobei, wenn der erste Typ der P-Typ ist und der zweite Typ der N-Typ ist, der erste Bereich mit N⁺ dotiert ist und der zweite Bereich mit N⁰ dotiert ist, oder der erste Bereich mit N⁰ dotiert ist und der zweite Bereich mit N⁺ dotiert ist.

12. Asymmetrischer bistabiler zweipoliger Widerstand vom vertikalen Typ nach Anspruch 10, wobei, wenn der erste Typ der N-Typ ist und der zweite Typ der P-Typ ist, der erste Bereich mit P⁺ dotiert ist und der zweite Bereich mit P⁰ dotiert ist, oder der erste Bereich mit P⁰ dotiert ist und der zweite Bereich mit P⁺ dotiert ist.

13. Asymmetrischer bistabiler zweipoliger Widerstand vom vertikalen Typ nach Anspruch 10, wobei, wenn der erste Typ der P-Typ ist und der zweite Typ der N-Typ ist, die Ausgleichsbandenergie der ersten und der dritten Halbleiterschicht höher ist als die Ausgleichsbandenergie der zweiten Halbleiterschicht, und die Leitungsbandenergie der zweiten Halbleiterschicht niedriger ist als die Leitungsbandenergie der ersten und dritten Halbleiterschicht.

14. Asymmetrischer bistabiler zweipoliger Widerstand vom vertikalen Typ nach Anspruch 10, wobei, wenn der erste Typ der N-Typ ist und der zweite Typ der P-Typ ist, die Ausgleichsbandenergie der ersten und der dritten Halbleiterschicht niedriger ist als die Ausgleichsbandenergie der zweiten Halbleiterschicht, und die Leitungsbandenergie der zweiten Halbleiterschicht höher ist als die Leitungsbandenergie der ersten und dritten Halbleiterschicht.

## Revendications

1. Procédé de fabrication d'un biristor asymétrique à deux bornes de type vertical, consistant à :
former une première couche semi-conductrice (310) sur un substrat (300) comprenant du germanium ;
former une deuxième couche semi-conductrice (320) à base de germanium comprenant une première zone (321) et une seconde zone (322) qui présentent une concentration de dopage différente sur la première couche semi-conductrice ; et à
former une troisième couche semi-conductrice (330) à base de germanium sur la deuxième couche semi-conductrice, le type de conductivité des première et troisième couches semi-conductrices étant différent du type de conductivité de la deuxième couche semi-conductrice, le procédé étant **caractérisé en ce que** la formation de la deuxième couche semi-conductrice se fait par le laminage d'une pluralité de substances ayant une énergie de bande interdite différente de façon à former un puits d'énergie.

2. Procédé selon la revendication 1, dans lequel le substrat comprenant du germanium comprend du Ge (germanium) pur ou du GeOI (Ge sur isolant) ou du SGOI (germanium contraint sur isolant).

3. Procédé selon la revendication 1, dans lequel, lorsque les première et troisième couches semi-conductrices sont formées en type N, et que la deuxième couche semi-conductrice est formée en type P, l'énergie de bande d'équilibre des première et troisième couches semi-conductrices est inférieure à l'énergie de bande d'équilibre de la deuxième couche semi-conductrice, et l'énergie de bande de conduction de la deuxième couche semi-conductrice est supérieure à l'énergie de bande de conduction des première et troisième couches semi-conductrices.

4. Procédé selon la revendication 1, dans lequel, lorsque les première et troisième couches semi-conductrices sont formées en type P, et que la deuxième couche semi-conductrice est formée en type N, l'énergie de bande d'équilibre des première et troisième couches semi-conductrices est supérieure à l'énergie de bande d'équilibre de la deuxième couche semi-conductrice, et l'énergie de bande de conduction de la deuxième couche semi-conductrice est inférieure à l'énergie de bande de conduction des première et troisième couches semi-conductrices.

5. Procédé selon la revendication 1, dans lequel la formation de la deuxième couche semi-conductrice consiste à former la première zone en N⁺ et la seconde zone en N°, ou à former la première zone en N⁰ et de seconde zone en N⁺ lorsque les première et troisième couches semi-conductrices sont formées en type P.

6. Procédé selon la revendication 1, dans lequel la formation de la deuxième couche semi-conductrice consiste à former la première zone en P⁺ et la seconde zone en P⁰, ou à former la première zone en P⁰ et la seconde zone en P⁺ lorsque les première et troisième couches semi-conductrices sont formées en type N.

7. Procédé selon la revendication 1, dans lequel la formation des première à troisième couches semi-conductrices consiste à former une bande d'énergie interdite des première et troisième couches semi-conductrices de façon à ce qu'elle soit plus grande que la bande d'énergie interdite de la deuxième couche semi-conductrice.

8. Procédé selon l'une quelconque des revendications 1 à 7, consistant en outre à former des motifs et des gravures sur les couches semi-conductrices de façon à former une couche semi-conductrice active ; et à
déposer un ILD (diélectrique intercouche) et une ligne métallique.

9. Procédé selon la revendication 8, dans lequel la gravure forme un pilier, le procédé consistant en outre à former une couche d'oxyde sacrificiel sur la surface du pilier comprenant les première à troisième couches semi-conductrices qui sont formées verticalement par la gravure.

10. Biristor asymétrique à deux bornes de type vertical comprenant :
un substrat (300) à base de germanium ;
une première couche semi-conductrice (310) d'un premier type de conductivité, formée sur le substrat ;
une deuxième couche semi-conductrice (320) d'un deuxième type de conductivité, formée sur la première couche semi-conductrice et comprenant une première zone (321) et une seconde zone (322) qui présentent une concentration de dopage différente ; et
une troisième couche semi-conductrice (330) du premier type de conductivité, formée sur la deuxième couche semi-conductrice, le biristor étant **caractérisé en ce que** la deuxième couche semi-conductrice est formée par le laminage d'une pluralité de substances ayant une énergie de bande interdite différente afin de former un puits d'énergie.

11. Biristor asymétrique à deux bornes de type vertical selon la revendication 10, dans lequel, lorsque le premier type est de type P, et que le second type est de type N, la première zone est dopée par N⁺ et la seconde zone est dopée par N°, ou la première zone est dopée par N⁰ et la seconde zone est dopée par N⁺.

12. Biristor asymétrique à deux bornes de type vertical selon la revendication 10, dans lequel, lorsque le premier type est de type N, et que le second type est de type P, la première zone est dopée par P⁺ et la seconde zone est dopée par P⁰, ou la première zone est dopée par P⁰ et la seconde zone est dopée par P⁺.

13. Biristor asymétrique à deux bornes de type vertical selon la revendication 10, dans lequel, lorsque le premier type est de type P, et que le deuxième type est de type N, l'énergie de bande d'équilibre des première et troisième couches semi-conductrices est supérieure à l'énergie de bande d'équilibre de la deuxième couche semi-conductrice, et l'énergie de bande de conduction de la deuxième couche semi-conductrice est inférieure à l'énergie de bande de conduction des première et troisième couches semi-conductrices.

14. Biristor asymétrique à deux bornes de type vertical selon la revendication 10, dans lequel, lorsque le premier type est de type N, et que le deuxième type est de type P, l'énergie de bande d'équilibre des première et troisième couches semi-conductrices est inférieure à l'énergie de bande d'équilibre de la deuxième couche semi-conductrice, et l'énergie de bande de conduction de la deuxième couche semi-conductrice est supérieure à l'énergie de bande de conduction des première et troisième couches semi-conductrices.
